(19) **Europäisches Patentamt / European Patent Office / Office européen des brevets**

(11) **EP 2 293 323 A1**

(12) # EUROPEAN PATENT APPLICATION
published in accordance with Art. 153(4) EPC

(43) Date of publication:
**09.03.2011 Bulletin 2011/10**

(21) Application number: **09746471.3**

(22) Date of filing: **17.04.2009**

(51) Int Cl.:
*H01L 21/336* (2006.01)     *H01L 21/28* (2006.01)
*H01L 29/417* (2006.01)     *H01L 29/78* (2006.01)

(86) International application number:
**PCT/JP2009/057726**

(87) International publication number:
**WO 2009/139264 (19.11.2009 Gazette 2009/47)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **16.05.2008 JP 2008129692**

(71) Applicants:
• **National University Corporation Tohoku Unversity**
  **Sendai-shi, Miyagi 980-8577 (JP)**
• **Foundation for Advancement of International Science**
  **Tsukuba-shi, Ibaraki 305-0062 (JP)**

(72) Inventors:
• **OHMI, Tadahiro**
  **Sendai-shi**
  **Miyagi 980-8577 (JP)**
• **TERAMOTO, Akinobu**
  **Sendai-shi**
  **Miyagi 980-8577 (JP)**
• **TANAKA, Hiroaki**
  **Sendai-shi**
  **Miyagi 980-8577 (JP)**
• **ISOGAI, Tatsunori**
  **Sendai-shi**
  **Miyagi 981-0933 (JP)**

(74) Representative: **Glawe, Delfs, Moll**
  **Patent- und Rechtsanwälte**
  **Postfach 26 01 62**
  **80058 München (DE)**

(54) **CONTACT FORMING METHOD, SEMICONDUCTOR DEVICE MANUFACTURING METHOD AND SEMICONDUCTOR DEVICE**

(57)     A semiconductor device manufacturing method includes the steps of ion-implanting a p-type or an n-type impurity into a Si layer portion to become a p-type or an n-type contact region of a semiconductor device, forming a metal film for a contact on a surface of the contact region without performing heat treatment for activating implanted ions after the ion-implanting step, and forming a silicide of a metal of the metal film by causing the metal to react with the Si layer portion by heating. It is desired to simultaneously perform the step of forming the silicide and the step of activating the implanted ions by heat treatment after the metal film is formed.

FIG. 8

EP 2 293 323 A1

**Description**

Technical Field:

This invention relates to a MIS-type semiconductor device widely used in an IC, LSI, and the like and, in particular, to formation of a low-resistance contact between a highly-concentrated Si portion and a metal silicide in a source region and a drain region.

Background Art:

In a semiconductor device, it is strongly desired to achieve improvement in performance, such as improvement in operating frequency. However, in the semiconductor device, the improvement in performance is prevented by a series resistance between two main electrodes through which an electric current flows mainly. As a significant factor of the series resistance, a contact resistance between a highly-concentrated Si (silicon) layer and a metal silicide in a source region and a drain region is recognized. According to performance prediction by ITRS (International Technology Roadmap for Semiconductor) of the 2007 edition, it is shown that a current contact resistivity is $1 \times 10^{-7}\Omega cm^2$ and a predicted value for 2010 is $7.0 \times 10^{-8}\Omega cm^2$. At present, however, a manufacturing method for achieving a low contact resistance has not yet been established.
Non-Patent Document 1 describes that the contact resistance must be reduced.

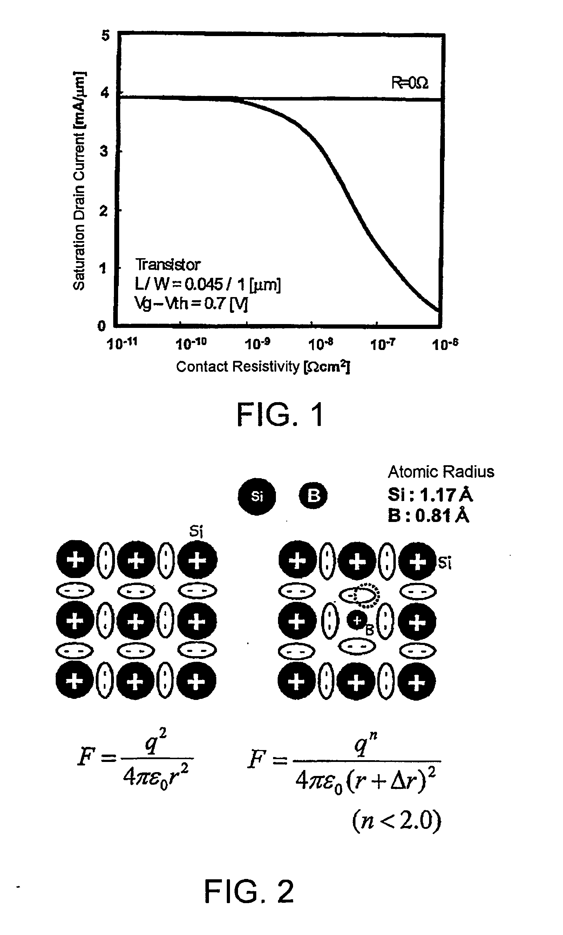

Fig. 1 shows a contact resistivity dependence of a saturation current in a MIS (Metal Insulator Semiconductor) transistor. It is understood that, if the contact resistivity is $1 \times 10^{-7}\Omega cm^2$ according to a conventional technique, only about 35% of original capacity of the transistor is extracted.
It is known that a contact resistance Rc between the highly-concentrated Si layer and metal/metal silicide is represented by the following Formula (1).
[Formula 1]

$$R_C \propto \exp\left[\frac{4\sqrt{(m_n \ or \ m_p)\varepsilon_s}}{h}\left(\frac{\phi_b}{\sqrt{n \ or \ p}}\right)\right] \qquad (1)$$

In Formula (1), $R_c$ is the contact resistance between the highly-concentrated Si layer and the metal/metal silicide, $\phi_b$ is a work function difference between the highly-concentrated Si layer and the metal/metal silicide, $m_n$ is an electron effective mass, mp is a hole effective mass, n is an electron density in an $n^+$ region, p is a hole density in a $p^+$ region, $\varepsilon_s$ is a permittivity of silicon, and h is a Planck's constant.
As apparent from Formula (1), as a method of reducing the contact resistance Rc, it is essential to reduce the work function difference between the highly-concentrated Si layer and the metal silicide and to maximize an impurity concentration of the highly-concentrated Si layer.

Prior Art Documents:

Non-Patent Documents:

Non-Patent Document 1: Tadahiro Ohmi, Akinobu Teramoto, Rihito Kuroda, and Naoto Miyamoto, "Revolutional Progress of Silicon Technologies Exhibiting Very High Speed Performance Over a 50-GHz Clock Rate", IEEE TRANSACTIONS ON ELECTRON DEVICES, VOL. 54, NO. 6, pp.1471-1477, June 2007
Non-Patent Document 2: Hajime Kumami, Wataru Shindo, Satoshi Hondo, Tadahiro Ohmi, "Plasma-Induced Dopant (As, P, Sb, B) Deactivation by Low-Energy Ion Irradiation during Silicon Epitaxial Growth", The Institute of Electronics, Information and Communication Engineers, Vol. 99, No. 231, Silicon Materials and Devices, ED99-97, SDM99-71, ICD99-79, pp. 97, 1999

Summary of the Invention:

Problem to be Solved by the Invention:

However, in a case of a p-type MOS (Metal Oxide Semiconductor) transistor, there is a problem that, in a conventional process, B (boron) used in the highly-concentrated Si layer is easily deactivated by a plasma damage due to ion irradiation during manufacture of a semiconductor device (See Non-Patent Document 2). The reason is as follows. As shown in Fig. 2, B is a trivalent atom and originally has covalent-bonding hands smaller in number by one with respect to Si to be covalently bonded. Furthermore, B has an atomic radius smaller than that of Si so that an atomic distance becomes long. Therefore, a coulomb force for covalent bonding is reduced.

Accordingly, in the conventional technique, even by the use of a metal silicide having a small work function difference with respect to the highly-concentrated Si layer, deactivation of a highly-concentrated Si region is unavoidable. Therefore, it is not possible to maximize an impurity concentration of the highly-concentrated Si layer. Thus, in the conventional technique, it has been difficult to reduce a resistivity at the contact.

Further, with the miniaturization of the semiconductor device, it is required to achieve expansion of the highly-concentrated Si layer in the source region and the drain region and ultra-shallow junction depth. It is noted here that, upon silicidation, in a case of a metal material requiring a high consumption of silicon, the highly-concentrated Si layer may be entirely silicided as a result of silicide formation to cause disruption of the junction. Accordingly, in the conventional technique, it is difficult to achieve the expansion of the highly-concentrated Si layer and the ultra-shallow junction depth.

It is therefore an object of the present invention to provide a contact forming method capable of increasing an impurity concentration by minimizing deactivation of impurities due to plasma damage of a highly-concentrated impurity layer in a contact region.

It is another object of the present invention to provide a semiconductor device having a low-resistivity contact formed of a metal silicide having a composition comprising a greater content of a metal with respect to Si.

Means to Solve the Problem:

According to a first aspect of the invention, it can be provided a method of forming a contact to a source region and a drain region of a semiconductor device. The method forms a metal film for the contact without performing heat treatment after ion implantation for forming a highly-concentrated Si layer and performs one or both of activation of the highly-concentrated Si layer and silicidation by subsequent heat treatment.

According to a second aspect of the invention, it can be provided a semiconductor device manufacturing method including the steps of ion-implanting a p-type or an n-type impurity into a Si layer portion to become a p-type or an n-type contact region of a semiconductor device, forming a metal film for a contact on a surface of the contact region without performing heat treatment for activating the implanted ions after the ion-implanting step, and forming a silicide of a metal of the metal film by causing the metal to react with the Si layer portion by heating.

According to a third aspect of the invention, it can be provided a semiconductor device manufacturing method including the steps of ion-implanting a p-type or an n-type impurity into a Si layer portion to become a p-type or an n-type contact region of a semiconductor device to amorphize a surface of the Si layer portion, forming a metal film for a contact on a surface of an amorphous Si portion, and forming a silicide of a metal of the metal film by causing the metal to react with the amorphous Si portion by heating.

In the first through third aspects, it is preferable that a metal of the metal film for a contact is a metal adapted to form a silicide having a work function difference of not greater than 0.3eV with respect to the highly-concentrated Si layer or a Si layer and it is desirable that a metal of the metal film for a contact is at least one of palladium, cobalt, nickel, rhodium, rhenium, osmium, iridium, platinum, and gold.

In the first through third aspects, it is preferable that the method further includes a step of activating, by heat treatment after the metal film is formed, ions implanted by the ion implantation. In this case, it is desirable that the silicide forming step and the activating step are performed at the same time.

Further, the contact region may be a source or a drain region of a field-effect transistor. It is desirable that the contact region is a p-type region and that a p-type impurity ion-implanted into the contact region is boron. It is also desirable that the metal is palladium.

According to a fourth aspect of the invention, it can be provided a semiconductor device having a source region and a drain region each formed of Si, a contact portion to at least one of the source region and the drain region containing a silicide of a predetermined metal, the metal forming the silicide is a metal such that the silicide has a composition comprising a greater content of the metal with respect to Si.

In the semiconductor device, it is desirable that the predetermined metal is palladium and the silicide is $Pd_2Si$ with a (104) surface.

Effect of the Invention:

According to the present invention, it is possible to increase an impurity concentration by avoiding deactivation of a highly-concentrated impurity region at a contact portion. Therefore, a resistivity at the contact can be reduced.

Further, according to the present invention, palladium requiring a low consumption of silicon Si is used in silicidation. Therefore, it is possible to prevent disruption of a junction as a result of silicide formation and to enable expansion of the highly-concentrated Si layer in a source region and a drain region and ultra-shallow junction depth. Thus, miniaturization of a semiconductor device can be accomplished.

Brief Description of the Drawings:

Fig. 1 is a view showing a contact resistivity dependence of a saturation current in a MIS transistor.

Fig. 2 is a schematic diagram of silicon crystals and a view for describing a coulomb force.

Fig. 3 shows X-ray analysis reciprocal lattice space mapping images when palladium is deposited on a Si (100) surface and heat treatment is executed at different temperatures to perform silicidation.

Fig. 4 shows X-ray analysis reciprocal lattice space mapping images when palladium is deposited on a Si (110) surface and heat treatment is executed at different temperatures to perform silicidation.

Fig. 5 shows X-ray analysis reciprocal lattice space mapping images when palladium is deposited on a Si (551) surface and heat treatments executed at different temperatures to perform silicidation.

Fig. 6 is a schematic diagram of a CMOS which is a first embodiment of the present invention and which is obtained by using shallow trench isolation, two-layer wiring, and chemical mechanical polishing.

Fig. 7 is a view for describing a part of a manufacturing process for obtaining the CMOS in Fig. 6.

Fig. 8 is a view for describing the rest of the manufacturing process subsequent to Fig. 7.

Fig. 9 is a schematic diagram of a Kelvin resistance for contact resistivity evaluation, which is a second embodiment of the present invention.

Fig. 10 is a view showing a current-voltage characteristic of the Kelvin resistance for contact resistivity evaluation, which is the second embodiment of the present invention.

Fig. 11 is a view showing a current-voltage characteristic of a Kelvin resistance manufactured by a conventional manufacturing method.

Embodiment for Carrying out the Invention:

In a recent semiconductor device, due to a series resistance in a highly-concentrated layer region and a contact region connected between main electrodes, it is difficult to achieve high performance in electric current driving ability. The reason is as follows. During manufacture of a semiconductor device using the plasma technique, due to influence of plasma, such as ion damage, deactivation of impurities in a highly-concentrated layer is caused to occur to increase the series resistance. Further, in order to reduce a resistance in the contact region, it is required to reduce a work function difference between silicon Si and a metal silicide. Furthermore, in miniaturization of the semiconductor device, it is desired to use, for a metal silicide used in the contact region, a metal material requiring a low consumption of silicon so as to provide a composition comprising a greater content of a metal with respect to silicon.

In an embodiment of the present invention which will be described hereinbelow, a process is executed which uses a contact material suitable for forming the metal silicide having a small work function difference with respect to the highly-concentrated Si layer and having a composition comprising a greater content of a metal with respect to Si and which is capable of suppressing deactivation of impurities in the highly-concentrated layer.

[First Embodiment]

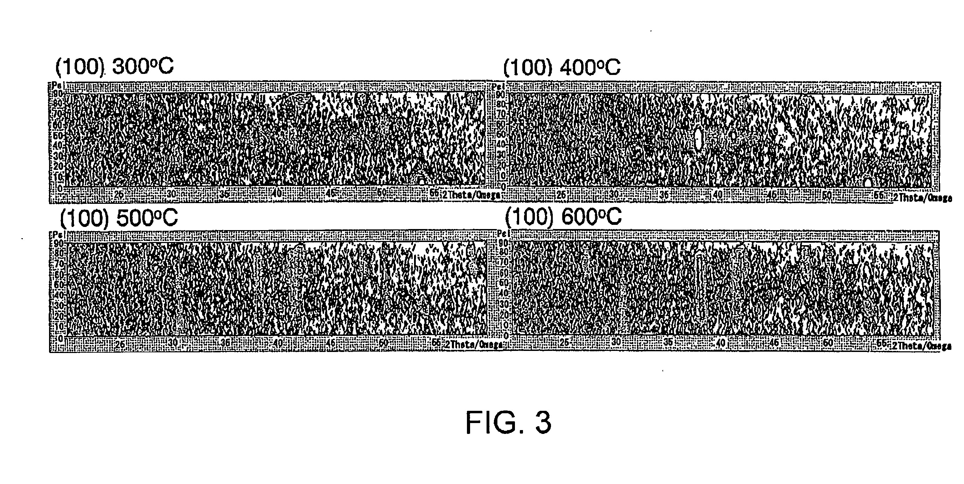

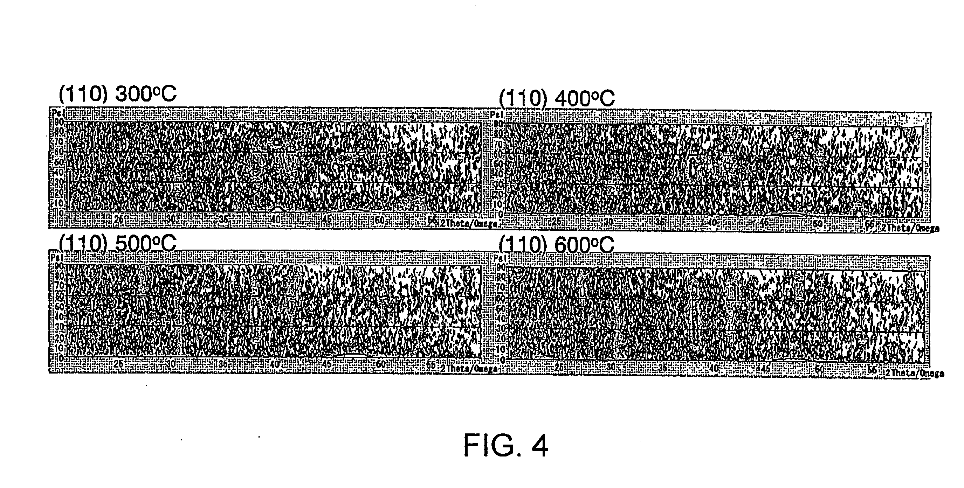

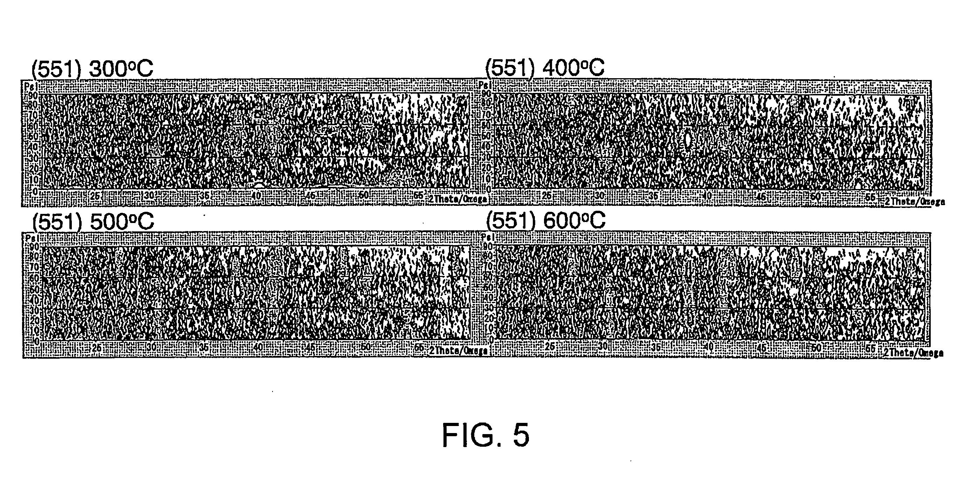

Figs. 3 to 5 show X-ray analysis reciprocal lattice space mapping images when palladium is deposited on each of Si (100), Si (110), and Si (551) surfaces and heat treatment is executed at different temperatures to perform silicidation. It is understood that, in any of Figs. 3 to 5, as the temperature is increased, $Pd_2Si$ of a composition comprising a greater content of a metal with respect to Si is formed and that a surface orientation is changed from a (001) surface to a (401) surface. Table 1 shows a work function difference (unit being eV) with respect to p-type Si in this case. It is understood that, by achieving the (401) surface of $Pd_2Si$, a work function difference of substantially not greater than 0.3eV is achieved regardless of a surface orientation of Si.

[Table 1]

|  | | as-depo | 300°C | 400°C | 500°C | 600°C |
|---|---|---|---|---|---|---|
|  | (100) | Pd 0.299eV | Pd$_2$Si 0.341 eV | Pd$_2$Si 0.340eV | Pd$_2$Si 0.300eV | Pd$_2$Si 0.290eV |
|  | (110) | Pd 0.306eV | Pd+ Pd$_2$Si 0.347eV | Pd$_2$Si 0.342eV | Pd$_2$Si 0.343eV | Pd$_2$Si 0.302eV |
|  | (551) | Pd 0.302eV | Pd+ Pd$_2$Si 0.347eV | Pd$_2$Si 0.341 eV | Pd$_2$Si 0.341 eV | Pd$_2$Si 0.287eV |

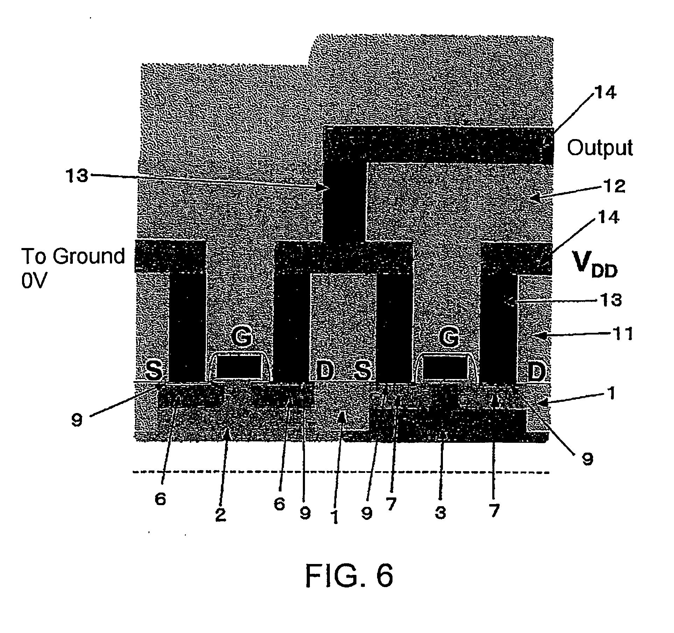

Fig. 6 shows a schematic diagram of a CMOS which is a first embodiment of the present invention and which is obtained by shallow trench isolation (STI), two-layer wiring, and chemical mechanical polishing (CMP).

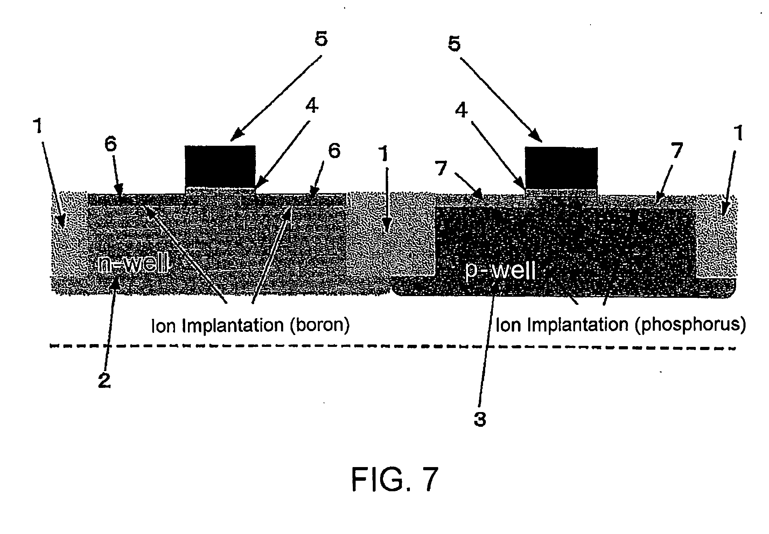

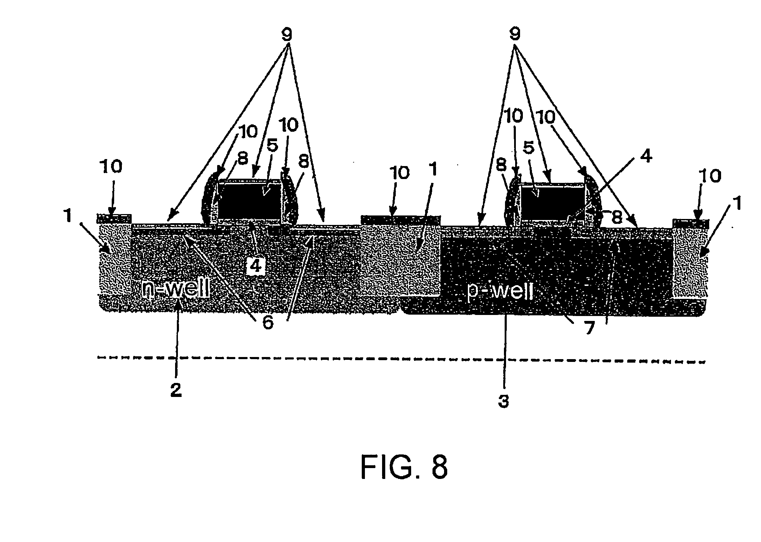

A manufacturing process for obtaining a structure in Fig. 6 will be described using Figs. 7 and 8.

First, referring to Fig. 7, device isolation regions 1 are formed by a STI structure like in a conventional method and an n-well 2 and a p-well 3 are formed and activated. Thereafter, as a gate insulating film 4, a silicon oxide film is formed to a thickness of 2nm. On the silicon oxide film, gate electrodes 5 are formed of polysilicon.

Next, in order to form a $p^+$ region 6 for the n-well 2 and to form an $n^+$ region 7 for the p-well 3, boron and phosphorus are ion-implanted into the n-well 2 and the p-well 3 at a dose of $6 \times 10^{15} cm^2$ to form the highly-concentrated regions 6 ($p^+$ region) and 7 ($n^+$ region) of 20nm, respectively. Fig. 7 shows a schematic diagram of this state.

In the conventional method, heat treatment is then performed for the purpose of activation of the highly-concentrated regions 6 and 7. However, in the process of the present invention, without performing the heat treatment at this stage, an oxide film is deposited by CVD (Chemical Vapor Deposition) and etching is performed to form sidewalls 8 as shown in Fig. 8. After the sidewalls 8 are formed, palladium is deposited to a thickness of 20nm as a contact metal to the highly-concentrated regions 6 and 7 and the gate electrodes 5.

In the present embodiment, heat treatment is then performed in a nitrogen atmosphere at 550°C for 1 hour to simultaneously achieve not only silicidation (formation of a contact silicide layer 9) but also activation of the highly-concentrated layers 6 and 7, which is not performed before. Because of the heat treatment at a low temperature, diffusion of the highly-concentrated regions can be prevented. At this time, Pd$_2$Si is formed by silicidation only at a base having a thickness of 13.6nm, consuming silicon of the highly-concentrated layers 6 and 7. A schematic diagram of this state is shown in Fig. 8.

Subsequently, unreacted metal portions 10 are removed in a manner similar to the conventional method. As shown in Fig. 6, interlayer insulating films 11 and 12 are formed, contact holes are formed and electrodes 13 and wirings 14 are formed of aluminum to reach completion. In Fig. 6, one of the highly-concentrated layers 6 and 7 is a source (S) and the other of the highly-concentrated layers 6 and 7 is a drain (D).

As described above, after ion implantation for forming the highly-concentrated layers is performed, a metal film is formed without performing heat treatment for activating impurities. Thereafter, by heat treatment, formation of the highly-concentrated Si layers by impurity activation and formation of the metal silicide are performed at the same time. Thus, a transistor is formed which has a work function difference of not greater than 0.3eV and which achieves a contact resistivity of $8.0 \times 10^{-10} \Omega cm^2$.

[Second Embodiment]

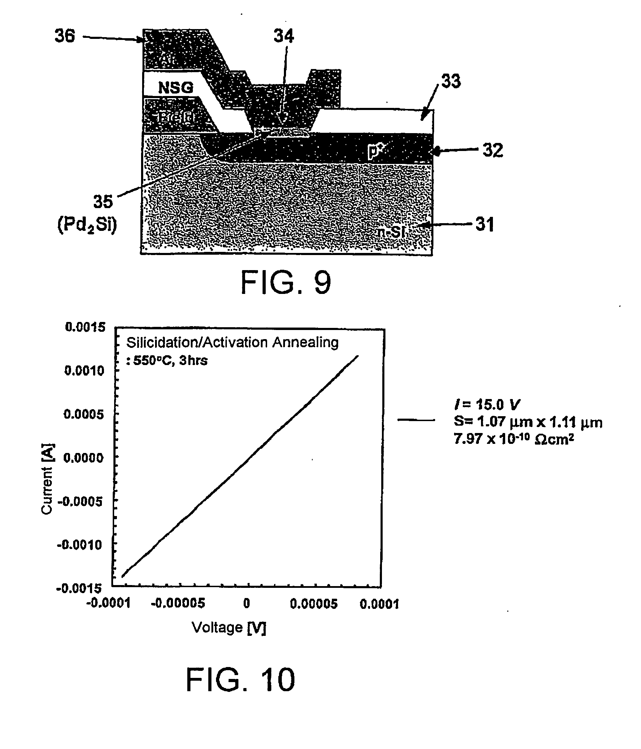

Fig. 9 shows a schematic diagram of a Kelvin resistance for contact resistivity evaluation, which is a second embodiment of the present invention. Boron is ion-implanted at a dose of $6 \times 10^{15} cm^2$ into a device region 31 of a Si (100) surface to form a highly-concentrated p region 32. Thereafter, without performing heat treatment, an interlayer insulating film 33 is formed. Subsequently, in the interlayer insulating film 33, a contact hole 34 for exposing a contact region is formed. Thereafter, as a metal film, palladium is deposited to 20nm. Heat treatment is performed in a nitrogen gas atmosphere at 550°C for 3 hours to form a highly-concentrated Si layer 32 by impurity activation and to form a metal silicide 35. At this time, the metal silicide 35 thus formed is Pd$_2$Si having a composition comprising a greater content of a metal with respect to Si and has a film thickness of 14nm, a (104) surface as a surface orientation, and a work function difference of not greater than 0.3eV with respect to p-type Si. Thereafter, an electrode/wiring 36 is formed of aluminum to reach completion.

Fig. 10 shows a current-voltage characteristic of the Kelvin resistance for contact resistivity evaluation which is the second embodiment of the present invention.

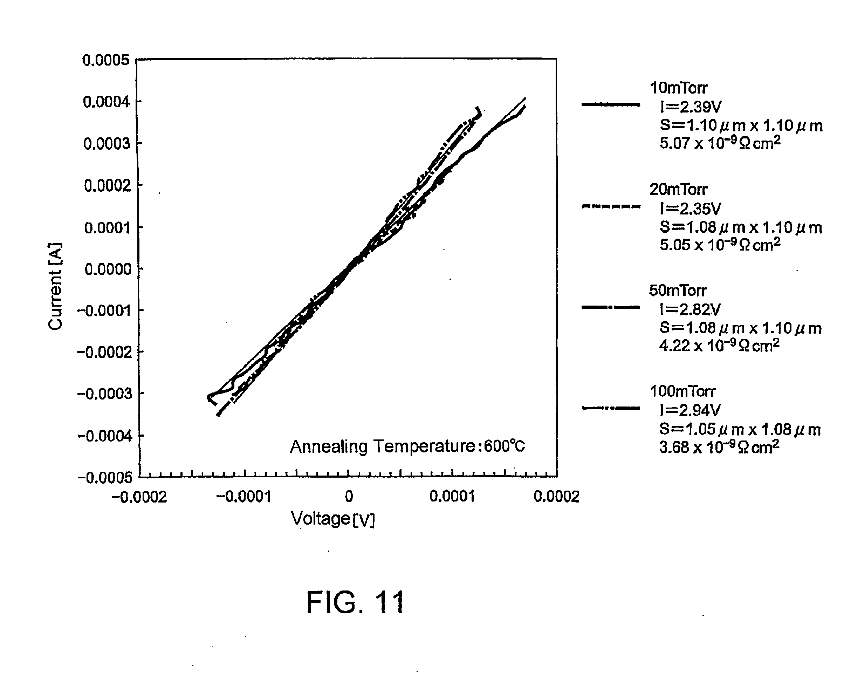

Fig. 11 shows a current-voltage characteristic of a Kelvin resistance according to the conventional technique by performing heat treatment after ion implantation, forming a highly-concentrated Si layer, thereafter performing deposition of an interlayer insulating film and formation of a contact region, then forming a metal film, and again performing heat treatment to silicide the metal film. By using a high pressure as a metal deposition pressure, plasma damage during sputtering deposition is reduced, deactivation of the highly-concentrated Si region is prevented, and a resistivity is reduced to some extent.

On the other hand, in the second embodiment, impurities are activated after the metal film is deposited, so that plasma damage caused by sputtering deposition is minimized. Further, by forming the metal film on amorphous Si after ion implantation and siliciding the metal film by heat treatment, silicidation easily progresses. As a consequence, resistivity is further reduced as compared with Fig. 11 and a low contact resistivity of $8.0 \times 10^{-10}\Omega cm^2$ is achieved.

At this time, a surface orientation of silicon may be not only a (100) surface but also any surface orientation such as a (110) surface, a (551) surface, or the like. Further, the metal may be not only palladium but also any metal material which is at least one of cobalt, nickel, rhodium, rhenium, osmium, iridium, platinum, and gold and which is adapted to form a silicide having a work function difference of not greater than 0.3eV with respect to the highly-concentrated layer.

When p-type or n-type impurities are ion-implanted into a silicon portion to become a contact region, a surface of the silicon portion is amorphized. In the conventional technique, an amorphous surface is crystallized when ions are subsequently activated by heat treatment and, therefore, a metal for a silicide adheres to the crystallized silicon surface. However, in the present invention, since the metal film for a silicide is formed on the amorphized silicon surface, the metal reacts with an amorphous silicon portion to thereby form a silicide of the metal. As a result, formation of a silicide becomes easy and a further reduced contact resistivity is obtained.

In the foregoing, the present invention has been described with reference to a plurality of embodiments. However, the present invention is not limited to the above-mentioned embodiments. Within the spirit and the scope of the present invention described in the claims, the structure and the details of the present invention may be modified in various manners which can be understood by persons skilled in the art. For example, at least one of the activation of the highly-concentrated layer and the silicidation must be performed. If both steps are performed, these steps need not simultaneously be performed but may be performed separately.

This application is based upon and claims the benefit of priority from Japanese patent application No. 2008-129692, filed on May 16, 2008, the disclosure of which is incorporated herein in its entirety by reference.

## Claims

1. A method of forming a contact to a source region and a drain region of a semiconductor device, **characterized by** forming a metal film for the contact without performing heat treatment after ion implantation for forming a highly-concentrated Si layer and performing one or both of activation of the highly-concentrated Si layer and silicidation by subsequent heat treatment.

2. The method of forming a contact as claimed in claim 1, **characterized in that** a metal of the metal film for a contact is a metal adapted to form a silicide having a work function difference of not greater than 0.3eV with respect to the highly-concentrated Si layer.

3. The method of forming a contact as claimed in claim 1, **characterized in that** a metal of the metal film for a contact is at least one of palladium, cobalt, nickel, rhodium, rhenium, osmium, iridium, platinum, and gold.

4. A semiconductor device manufacturing method **characterized by** including the steps of:

   ion-implanting a p-type or an n-type impurity into a Si layer portion to become a p-type or an n-type contact region of a semiconductor device;
   forming a metal film for a contact on a surface of the contact region without performing heat treatment for activating the implanted ions after the ion-implanting step; and
   forming a silicide of a metal of the metal film by causing the metal to react with the Si layer portion by heating.

5. A semiconductor device manufacturing method **characterized by** including the steps of:

   ion-implanting a p-type or an n-type impurity into a Si layer portion to become a p-type or an n-type contact region of a semiconductor device to amorphize a surface of the Si layer portion;
   forming a metal film for a contact on a surface of an amorphous Si portion; and
   forming a silicide of a metal of the metal film by causing the metal to react with the amorphous Si portion by heating.

6. The semiconductor device manufacturing method as claimed in claim 4 or 5, **characterized by** further including a step of activating, by heat treatment after the metal film is formed, ions implanted by the ion implantation.

7. The semiconductor device manufacturing method as claimed in claim 4, **characterized in that** the silicide forming step and the activating step are performed at the same time.

8. The semiconductor device manufacturing method as claimed in claim 4 or 5, **characterized in that** the contact region is a source or a drain region of a field-effect transistor.

9. The semiconductor device manufacturing method as claimed in claim 4 or 5, **characterized in that** the metal of the metal film for a contact is a metal adapted to form a silicide having a work function difference of not greater than 0.3eV with respect to the Si layer portion to become the p-type or the n-type contact region.

10. The semiconductor device manufacturing method as claimed in claim 4 or 5, **characterized in that** the metal of the metal film for a contact is at least one of palladium, cobalt, nickel, rhodium, rhenium, osmium, iridium, platinum, and gold.

11. The semiconductor device manufacturing method as claimed in claim 4 or 5, **characterized in that** the contact region is a p-type region.

12. The semiconductor device manufacturing method as claimed in claim 11, **characterized in that** a p-type impurity ion-implanted into the contact region is boron.

13. The semiconductor device manufacturing method as claimed in claim 4 or 5, **characterized in that** the metal is palladium.

14. A semiconductor device having a source region and a drain region each formed of Si, a contact portion to at least one of the source region and the drain region containing a silicide of a predetermined metal, **characterized in that**:

    the metal forming the silicide is a metal such that the silicide has a composition comprising a greater content of the metal with respect to Si.

15. The semiconductor device as claimed in claim 14, **characterized in that** the predetermined metal is palladium.

16. The semiconductor device as claimed in claim 14, **characterized in that** the predetermined metal is palladium and the silicide is $Pd_2Si$ with a (104) surface.

FIG. 1

Atomic Radius
Si : 1.17 Å
B : 0.81 Å

$$F = \frac{q^2}{4\pi\varepsilon_0 r^2}$$

$$F = \frac{q^n}{4\pi\varepsilon_0 (r + \Delta r)^2}$$

$$(n < 2.0)$$

FIG. 2

EP 2 293 323 A1

(100) 300°C

(100) 400°C

(100) 500°C

(100) 600°C

FIG. 3

EP 2 293 323 A1

(110) 300ºC

(110) 400ºC

(110) 500ºC

(110) 600ºC

FIG. 4

FIG. 5

FIG. 6

5    5

4

1    4    1

6    6    7    7    1

n-well    p-well

Ion Implantation (boron)    Ion Implantation (phosphorus)

2    3

FIG. 7

FIG. 8

FIG. 9

Silicidation/Activation Annealing
: 550°C, 3hrs

$I$ = 15.0 V
S= 1.07 μm x 1.11 μm
7.97 x 10⁻¹⁰ Ωcm²

FIG. 10

FIG. 11

EP 2 293 323 A1

<table>
<tr><td colspan="2" align="center">**INTERNATIONAL SEARCH REPORT**</td><td>International application No.<br>PCT/JP2009/057726</td></tr>
</table>

A.   CLASSIFICATION OF SUBJECT MATTER
*H01L21/336*(2006.01)i, *H01L21/28*(2006.01)i, *H01L29/417*(2006.01)i,
*H01L29/78*(2006.01)i

According to International Patent Classification (IPC) or to both national classification and IPC

B.   FIELDS SEARCHED

Minimum documentation searched (classification system followed by classification symbols)
H01L21/336, H01L21/28, H01L29/417, H01L29/78

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>Y | JP 9-17883 A  (Sharp Corp.),<br>17 January, 1997 (17.01.97),<br>Par. Nos. [0021], [0027], [0029], [0030]<br>& US 2002/0043689 A1 | 1-12<br>13-16 |
| X<br>Y | JP 2004-158627 A  (Renesas Technology Corp.),<br>03 June, 2004 (03.06.04),<br>Par. Nos. [0064] to [0065]<br>& US 2004/0087118 A1    & KR 10-2004-0040326 A | 1-12<br>13-16 |
| X<br>Y | JP 2002-141504 A  (International Business<br>Machines Corp.),<br>17 May, 2002 (17.05.02),<br>Par. Nos. [0024], [0029], [0031] to [0034]<br>& US 6410430 B1 | 1-12<br>13-16 |

[X]   Further documents are listed in the continuation of Box C.   ☐   See patent family annex.

| | |
|---|---|
| *   Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>   08 May, 2009 (08.05.09) | Date of mailing of the international search report<br>   19 May, 2009 (19.05.09) |
|---|---|
| Name and mailing address of the ISA/<br>   Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2009/057726 |

C (Continuation).   DOCUMENTS CONSIDERED TO BE RELEVANT

| Category* | Citation of document, with indication, where appropriate, of the relevant passages | Relevant to claim No. |
|---|---|---|
| Y | J.F.Chen et al., Epitaxial growth and thermal stability of thin $Pd_2Si$ films on (001), (011) and (111)Si, Thin Solid Films, 1995, Volume 261, Issues 1-2, pp.107-114 | 13-16 |
| A | JP 4-349660 A  (Toshiba Corp.), 04 December, 1992 (04.12.92), Par. No. [0025] (Family: none) | 11,12 |
| A | G.Ottaviani et al., Barrier heights and silicide formation for Ni, Pd, and Pt on silicon, PHYSICAL REVIEW B, 1981, VOLUME 24, NUMBER 6, pp.3354-3359 | 13-16 |
| A | JP 6-53233 A  (Toshiba Corp.), 25 February, 1994 (25.02.94), Par. No. [0022] (Family: none) | 1-16 |
| A | JP 11-111982 A  (LG Semicon Co., Ltd.), 23 April, 1999 (23.04.99), Par. Nos. [0007] to [0010] & US 5953616 A           & KR 10-0268871 B | 5 |

Form PCT/ISA/210 (continuation of second sheet) (April 2007)

## INTERNATIONAL SEARCH REPORT

International application No.

PCT/JP2009/057726

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
   There must exist a special technical feature that links a group of inventions to form a single general inventive concept to have the group of inventions in claims satisfy the requirement of unity of invention. The group of inventions in claims 1-14 are linked by the feature of having a contact composed of "metal silicide" in "a source region and a drain region".
   This feature, however, cannot be a special technical feature, since it is a well-known technical feature among those skilled in the art, without requiring exemplification.  (Continued to extra sheet.)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

| INTERNATIONAL SEARCH REPORT | International application No. |
|---|---|
| | PCT/JP2009/057726 |

Continuation of Box No.III of continuation of first sheet(2)

    As a result, there exists no special technical feature among the group of inventions in claims 1-14 so as to link them to form a single general inventive concept.  Therefore, it is clear that the group of inventions in claims 1-14 do not satisfy the requirement of unity of invention.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2008129692 A

### Non-patent literature cited in the description

- **Tadahiro Ohmi ; Akinobu Teramoto ; Rihito Kuroda ; Naoto Miyamoto.** Revolutional Progress of Silicon Technologies Exhibiting Very High Speed Performance Over a 50-GHz Clock Rate. *IEEE TRANSACTIONS ON ELECTRON DEVICES,* June 2007, vol. 54 (6), 1471-1477

- Plasma-Induced Dopant (As, P, Sb, B) Deactivation by Low-Energy Ion Irradiation during Silicon Epitaxial Growth. **Hajime Kumami ; Wataru Shindo ; Satoshi Hondo ; Tadahiro Ohmi.** Silicon Materials and Devices. The Institute of Electronics, Information and Communication Engineers, 1999, vol. 99, 97